# EUROPÄISCHE PATENTANMELDUNG

(11) **EP 1 657 971 A1**
(43) Veröffentlichungstag der Anmeldung: **17.05.2006**
(21) Anmeldenummer: 05110439.6
(22) Anmeldetag: 08.11.2005
(51) Int. Cl.: H05K 1/18, H05K 3/32, H05K 7/12, H05K 1/00

(54) **Anordnung aus einem elektronischen Bauelement und einem flexiblen Schaltungsträger**

(30) Priorität: 13.11.2004 DE 102004054985
(71) Anmelder: Hella KGaA Hueck & Co., 59552 Lippstadt (DE)
(72) Erfinder: Masjost, Ulrich, 59556 Lippstadt (DE)

(57) **Zusammenfassung**

Anordnung aus einem elektronischen Bauelement (4) und einem flexiblen Schaltungsträger (1), wobei das Bauelement (4) eine Außenfläche hat, an welcher der Schaltungsträger (1) in einem gebogenen Zustand anliegt, wobei der Schaltungsträger (1) und das Bauelement (4) über Rastelemente (3, 4, 5, 6) miteinander verbunden sind.

## Beschreibung

### STAND DER TECHNIK

Die Erfindung betrifft eine Anordnung aus einem elektrischen Bauelement und einem flexiblen Schaltungsträger, wobei das Bauelement eine Außenfläche hat, an welcher der Schaltungsträger in einem gebogenen Zustand anliegt.

Eine derartige Anordnung ist aus der Druckschrift mit der Veröffentlichungsnummer DE 102 12 794 A1 bekannt. Diese Druckschrift offenbart in den Fig. 1 bis 3 ein Kunststoffspritzgussteil mit einem eingespritzten Modul, wobei das Modul eine flexible mit Elektronikbauelementen bestückte, in ein Weichkunststoffmaterial eingegossene Leitplatte umfasst. Das Modul wird von der in die Weichkunststoffmasse eingebetteten flexiblen Leiterplatte ausgebildet. Die zunächst nicht gebogene Leiterplatte wird zur Montage des Moduls in einen gebogenen Zustand gebracht und dann mit der Weichkunststoffmasse vergossen. Der Vergussprozess findet bei knapp 100° statt. Im erstarrten Zustand fixiert dann die Weichkunststoffmasse die Leiterplatte, so dass die Form der Leiterplatte beibehalten wird. Das so geformte Modul kann dann entsprechend dem angedachten Zweck weiterverwendet werden.

Die Herstellung des Moduls, d. h. eine Anordnung aus einem Schaltungsträger und einem elektronischen Bauelement nach dem in der genannten Druckschrift beschriebenen Verfahren ist aufwändig und daher kostenintensiv.

Der Erfindung liegt daher die Aufgabe zugrunde, eine einfachere und kostengünstigere Anordnung der eingangs genannten Art vorzuschlagen.

### VORTEILE DER ERFINDUNG

Diese Aufgabe wird erfindungsgemäß dadurch gelöst, dass der Schaltungsträger und das Bauelement über Rastelemente miteinander verbunden sind und das Bauelement den gebogenen Schaltungsträger im montierten Zustand der Anordnung in der gewünschten Stellung fixiert.

Das Bauelement einer erfindungsgemäßen Anordnung kann als erstes Rastelement zumindest einen Rasthaken aufweisen. Der Schaltungsträger einer erfindungsgemäßen Anordnung kann als erstes Rastelement zumindest eine erste Rastausnehmung aufweisen, wobei diese erste Rastausnehmung mit dem Rasthaken zur Verbindung des Schaltungsträgers und des Bauelements zusammenwirken kann. Der Rasthaken kann beispielsweise die Rastausnehmung durchgreifen und einen Rand der ersten Rastausnehmung hintergreifen.

Das Bauelement einer erfindungsgemäßen Anordnung kann als zweites Rastelement zumindest einen Raststift aufweisen. Der Raststift kann dabei beispielsweise durch einen Anschlusspin des Bauelements gebildet sein. Der Schaltungsträger kann zweite Rastelemente aufweisen, die durch zweite Rastausnehmungen gebildet sind. Die Raststifte können dann im montierten Zustand die zweiten Rastausnehmungen durchgreifen.

Der Schaltungsträger und das Bauelement einer erfindungsgemäßen Anordnung sind vorteilhaft durch Formschluss miteinander verbunden. Die Verbindung kann so ausgestaltet sein, dass sie ausschließlich durch Formschluss gegebenenfalls unter Form- und Kraftschluss hergestellt ist.

Eine erfindungsgemäße Anordnung kann in einem Türgriff für ein Kraftfahrzeug eingesetzt sein.

### ZEICHNUNGEN

Ein Ausführungsbeispiel für eine erfindungsgemäße Anordnung aus einem elektrischen Bauelement und einem flexiblen Schaltungsträger sowie die Montage der Anordnung ist anhand der Zeichnung näher erläutert. Darin zeigt
- Fig. 1: eine Ansicht des Schaltungsträgers und des Bauelements vor einem ersten Montageschritt,
- Fig. 1a: eine Einzelheit aus Fig. 1,
- Fig. 2: eine Ansicht des Schaltungsträgers und des Bauelements nach einem ersten Montageschritt,
- Fig. 2a: eine Einzelheit aus Fig. 2,
- Fig. 3: die erfindungsgemäße Anordnung, d. h. den Schaltungsträger und das Bauelement nach einem letzten Montageschritt, und
- Fig. 3a: eine Einzelheit aus Fig. 3.

### BESCHREIBUNG DER AUSFÜHRUNGSBEISPIELE

Der Schaltungsträger 1 ist aus einem flexiblen Material hergestellt. In einem entspannten Zustand ist der Schaltungsträger 1 weitgehend eben. Der Schaltungsträger 1 weist eine erste Rastausnehmung 2 auf. Beabstandet von dieser ersten Rastausnehmung 2 sind insgesamt fünf zweite Rastausnehmungen 3 angeordnet.

Das elektronische Bauelement 4 weist eine Außenfläche auf, die gewölbt ist. Die Außenfläche des Bauelements 4 soll an dem Schaltungsträger anliegen, wobei dann der Schaltungsträger 1 entsprechend der Wölbung gebogen ist. Die Außenfläche des Bauelements gibt somit die Form des Schaltungsträgers 1 vor, die der Schaltungsträger 1 im montierten Zustand haben soll.

An der Außenfläche und aus der Außenfläche herausragend ist ein Rasthaken 5 vorgesehen. Dieser Rasthaken 5 wirkt zur Verbindung des Bauelements 4 mit dem Schaltungsträger 1 mit der ersten Rastausnehmung 2 zusammen.

Ferner sind aus der Außenfläche herausragende Raststifte 6 vorgesehen. Diese Raststifte 6 wirken zur Verbindung des Bauelements 4 mit dem Schaltungsträger 1 mit den zweiten Rastausnehmungen 3 zusammen. Der Abstand der Raststifte 6 vom Rasthaken 5 entspricht daher dem Abstand der zweiten Rastausnehmungen 3 von der ersten Rastausnehmung 2.

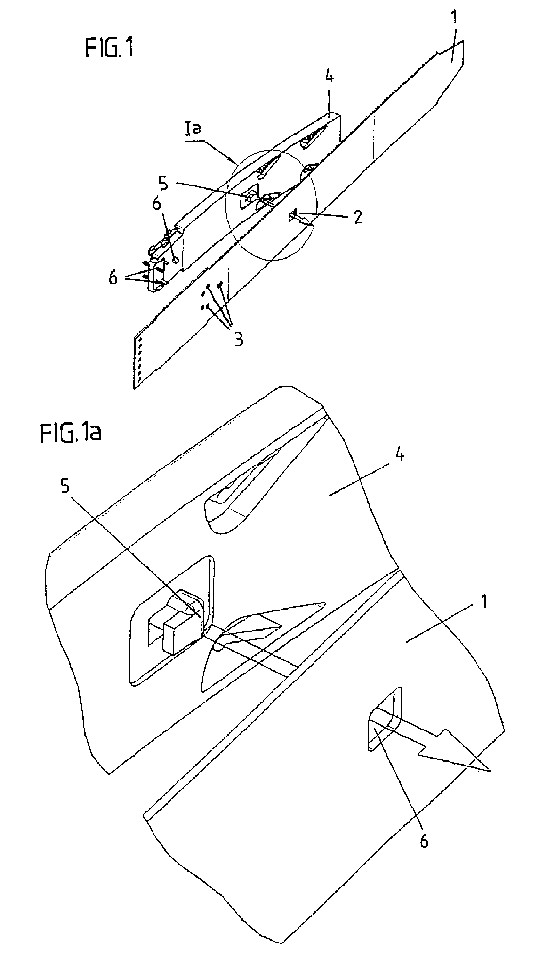

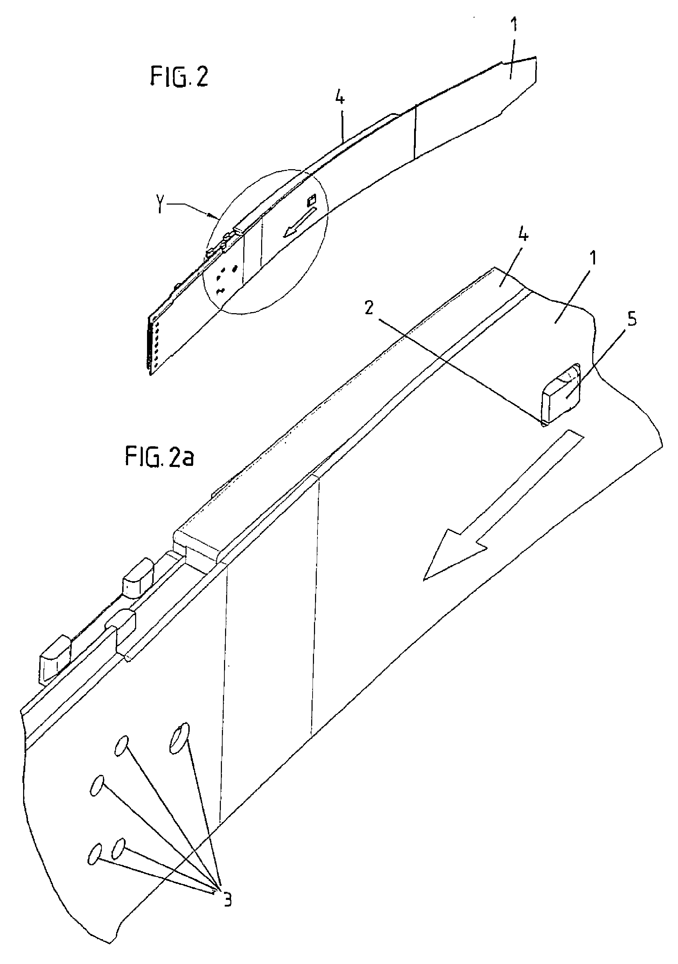

Zur Montage der Anordnung wird das Bauelement 4 in Richtung des Pfeils (Fig. 1, Fig. 1a) auf den Schaltungsträger 1 zu bewegt. Der Rasthaken 5 wird dabei durch die erste Rastausnehmung 6 durchgeschoben. Die Raststifte 6 des Bauelements 4 kommen dabei versetzt zu den zweiten Rastausnehmungen 3 an der dem Bauelement 4 zugewandten Außenseite des Schaltungsträgers 1 zum Liegen. Diese Stellung des Bauelements 4 zum Schaltungsträger 1 ist in Fig. 2 beziehungsweise Fig. 2a dargestellt.

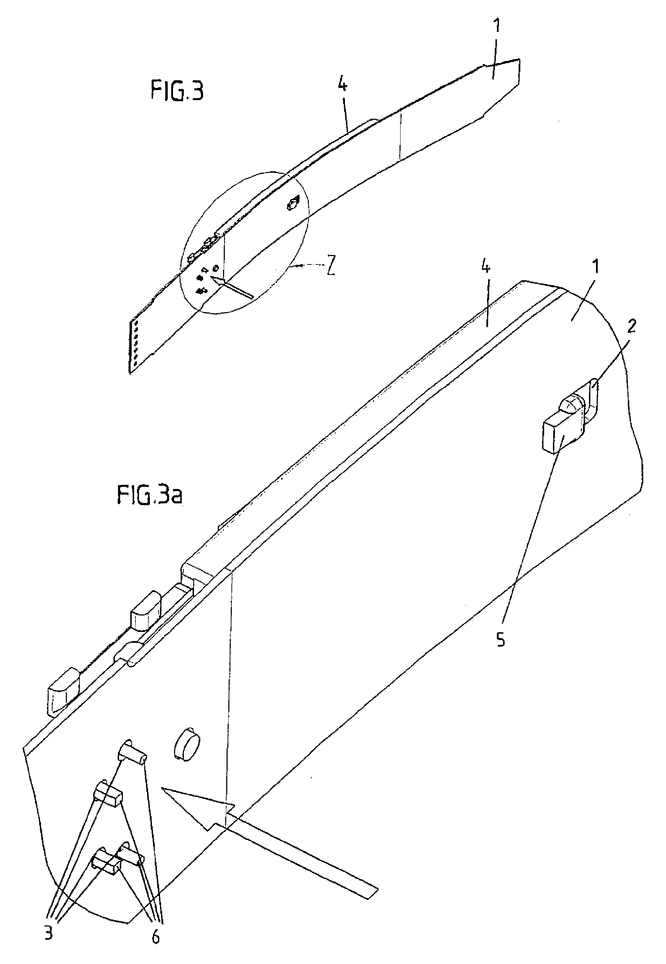

In einem zweiten Schritt wird dann das Bauelement 4 entsprechend der Pfeilrichtung (Fig. 2, Fig. 2a) seitlich zum Schaltungsträger 1 verschoben. Durch das Verschieben wird zweierlei erreicht. Zum einen hintergreift der Rasthaken 5 den Rand der ersten Rastausnehmung 2 und zum anderen kommen die Raststifte 6 in Flucht mit den zweiten Rastausnehmungen 3. Dadurch kann der Schaltungsträger 1 die in der Fig. 3 beziehungsweise 3a dargestellte Pfeilrichtung einschnappen. Es besteht dadurch eine formschlüssige Verbindung zwischen dem Schaltungsträger 1 und dem Bauelement 4 und die erfindungsgemäße Anordnung ist hergestellt (Fig. 3, Fig. 3a).

## Patentansprüche

1. Anordnung aus einem elektronischen Bauelement (4) und einem flexiblen Schaltungsträger (1), wobei das Bauelement (4) eine Außenfläche hat, an welcher der Schaltungsträger (1) in einem gebogenen Zustand anliegt,
**dadurch gekennzeichnet,**
**dass** der Schaltungsträger (1) und das Bauelement (4) über Rastelemente (3, 4, 5, 6) miteinander verbunden sind.

2. Anordnung nach Anspruch 1, **dadurch gekennzeichnet, dass** das Bauelement (4) als erstes Rastelement zumindest einen Rasthaken (5) aufweist.

3. Anordnung nach Anspruch 1 oder 2, **dadurch gekennzeichnet, dass** der Schaltungsträger (1) als erstes Rastelement zumindest eine erste Rastausnehmung (2) aufweist.

4. Anordnung nach Anspruch 2 und 3, **dadurch gekennzeichnet, dass** der Rasthaken (5) die erste Rastausnehmung (2) durchgreift und einen Rand der ersten Rastausnehmung (2) hintergreift.

5. Anordnung nach einem der Ansprüche 1 bis 4, **dadurch gekennzeichnet, dass** das Bauelement (4) als zweites Rastelement zumindest einen Raststift (6) aufweist.

6. Anordnung nach Anspruch 5, **dadurch gekennzeichnet, dass** der Raststift (6) durch einen Anschlusspin gebildet wird.

7. Anordnung nach einem der Ansprüche 1 bis 6, **dadurch gekennzeichnet, dass** der Schaltungsträger (1) als zweites Rastelement zumindest eine zweite Rastausnehmung (3) aufweist.

8. Anordnung nach den Ansprüchen 5 und 7 oder 6 und 7, **dadurch gekennzeichnet, dass** der Raststift (6) die zweite Rastausnehmung (3) durchgreift.

9. Anordnung nach einem der Ansprüche 1 bis 8, **dadurch gekennzeichnet, dass** der Schaltungsträger (1) und das Bauelement (4) durch Formschluss miteinander verbunden sind.
